# EUROPEAN PATENT SPECIFICATION

(11) **EP 3 845 485 B1**
(45) Date of publication and mention of the grant of the patent: **12.06.2024**
(21) Application number: 19853390.3
(22) Date of filing: 15.08.2019
(51) Int. Cl.: G01K 7/18, G01K 7/02, B81B 7/00, B81C 1/00, G01K 1/20

(54) **TEMPERATURE SENSOR MANUFACTURING METHOD**
TEMPERATURSENSORHERSTELLUNGSVERFAHREN
PROCÉDÉ DE FABRICATION DE CAPTEUR DE TEMPÉRATURE

(30) Priority: 28.08.2018 CN 201810989109
(43) Date of publication of application: 07.07.2021
(73) Proprietor: CSMC Technologies Fab2 Co., Ltd., Jiangsu 214028 (CN)
(72) Inventor: SU, Jiale, Wuxi New District Jiangsu 214028 (CN); ZHOU, Guoping, Wuxi New District Jiangsu 214028 (CN); ZHANG, Xinwei, Wuxi New District Jiangsu 214028 (CN); XIA, Changfeng, Wuxi New District Jiangsu 214028 (CN)
(74) Representative: Noble, Nicholas
(86) International application number: PCT/CN2019/100679
(87) International publication number: WO 2020/042913

(56) References cited:
- CN-A- 105 036 059
- CN-Y- 2 767 978
- CN-Y- 2 767 978
- US-A- 5 805 049
- US-A- 5 830 372
- US-A1- 2007 298 534
- US-A1- 2017 288 125

## Description

### CROSS REFERENCE TO RELATED APPLICATIONS

### TECHNICAL FIELD

The present application relates to the field of temperature sensor, and in particular to a manufacturing method for a temperature sensor.

### BACKGROUND

A temperature sensor includes a temperature measurement unit and a substrate carrying the temperature measurement unit. The substrate of the temperature sensor is usually made of a material with low thermal conductivity, such as depositing a temperature measurement material on silicon dioxide to form a temperature sensor. In the manufacturing process, by oxidizing a silicon wafer, a layer of silicon dioxide is produced on the surface of the silicon wafer. The thermal conductivity of silicon dioxide is low, but the thermal conductivity of silicon is high. In order to avoid conducting heat through the silicon at the bottom of the substrate, it is usually necessary to etch the silicon on the back of the silicon oxide layer by means of deep trench etching, such as wet etching with potassium hydroxide etching solution, or dry etching with a deep reactive ion etching process. Whether it is wet etching or dry etching, the process time thereof is long and the cost is high.

US5805049A relates to a temperature-measuring-resistor which comprises vanadium oxide as a matrix material. The matrix material further contains at least one member selected from a metal, a metal oxide and a metal nitride, and the member has an electric conductivity higher than that of the vanadium oxide. The temperature-measuring-resistor has a low room temperature resistivity, and a volume resistivity that varies greatly with temperature.

US5830372A relates to thermal sensor/actuator in semiconductor material. Semiconductor component with monolithically integrated electronic circuits and monolithically integrated sensor/actuator, whereby the sensor/actuator is manufactured with methods of surface micromachining in a sensor layer of polysilicon that is structured, for example, with sensor webs, and these sensor webs are thermally insulated from a silicon substrate by a cavity that is produced in a sacrificial layer and is closed gas-tight toward the outside with a closure layer.

### SUMMARY

The present application provides a manufacturing method for a temperature sensor, and a temperature sensor.

A manufacturing method for a temperature sensor, includes:
forming a plurality of trenches on a silicon wafer;
performing thermal annealing to deform the plurality of trenches, such that the plurality of trenches are in communication with each other to form a cavity, and the silicon wafer is connected together above the cavity to seal the cavity;
oxidizing silicon above the cavity to obtain a silicon oxide film; and
forming a temperature measurement unit on the silicon oxide film, and the temperature measurement unit is configured to sense an ambient temperature.

The details of one or more embodiments of the application are set forth in the accompanying drawings and description below Other features, purposes and advantages of the present application will become apparent from the description, the accompanying drawings, and the claims.

### BRIEF DESCRIPTION OF THE DRAWINGS

To better describe and illustrate embodiments and/or examples of the application disclosed herein, reference can be made to one or more accompanying drawings.
FIG. 1 is a method flowchart of a manufacturing method for a temperature sensor according to the present invention.
FIGS. 2a to 2c are cross-sectional views of the structures corresponding to steps of a manufacturing method for a temperature sensor according to the present invention.
FIG. 3 is a side view of a temperature sensor.
FIG. 4 is a top view of the temperature sensor corresponding to FIG. 3.
FIG. 5 is a side view of a temperature sensor.
FIG. 6 is a top view of the temperature sensor corresponding to FIG. 5.

### DETAILED DESCRIPTION

In order to facilitate the understanding of the present application, the present application will be described more fully hereinafter with reference to the related accompanying drawings.

All technical and scientific terms used herein have the same meaning as commonly understood by one of ordinary skill in the art to which this application applies, unless otherwise defined. The terms used in the specification of present application herein are for the purpose of describing specific embodiments only and are not intended to limit the present application. The term "and/or" used herein includes any and all combinations of one or more of the associated listed items.

In order to thoroughly understand the present application, detailed steps and structures will be set forth in the following description, so as to explain the technical solutions proposed by the present application. Preferred embodiments of the present application are described in detail below, however in addition to this detailed description, the present application may have other embodiments.

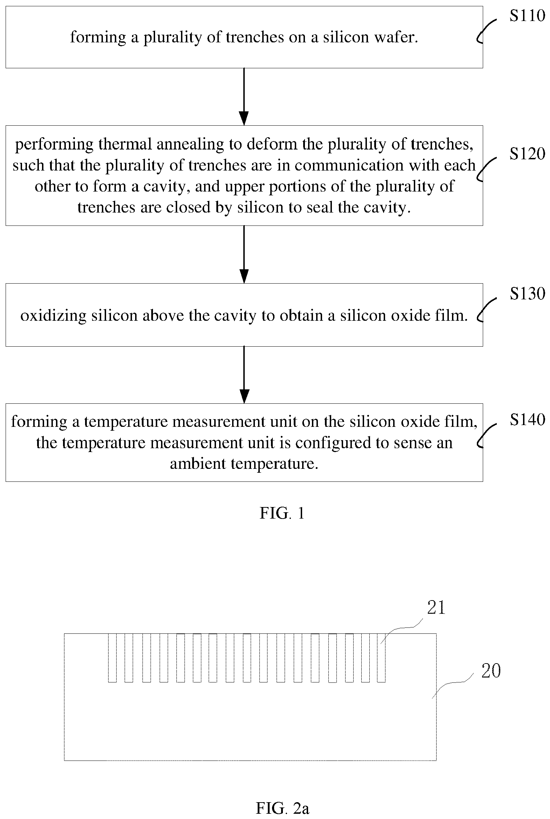

The present invention provides a manufacturing method for a temperature sensor, as shown in FIG. 1, the steps thereof includes:
Step S110: forming a plurality of trenches on a silicon wafer.

As shown in combination with FIG. 2a, a silicon wafer 20 is acquired, and a plurality of parallel trenches 21 is defined vertically downward from the top of the silicon wafer 20 to form a trench array. In an embodiment, a photoresist layer with an array pattern is formed on the silicon wafer 20 first, and then etching is performed on the silicon wafer 20 to form a plurality of trenches 21 by using the photoresist as a mask. In this embodiment, the etching may be conventional dry etching, specifically deep ion etching. Dry etching has higher etching accuracy and better anisotropy performance, and its accuracy can reach sub-micron level. Through dry etching, trenches with a better shape can be obtained, especially when the size of the trench is small, using the dry etching can reach a better effect. Different shapes of trenches can be obtained by adjusting the pattern of the mask and controlling the parameters of the etching. The width of the trench 21 may be 0.6-1 µm, the depth of the trench 21 may be 1-10 µm, and the spacing between adjacent trenches 21 may be 0.6-1 µm. The top-view shape of the trench 21 may be a circle, a square or other shape. The width of the trench is the maximum distance between the sidewalls of the trench. If the trench is circular, the width of the trench is the diameter of the trench. If the trench is square, the width of the trench is the diagonal distance of the trench.

Step S120: performing thermal annealing to deform the plurality of trenches, such that the plurality of trenches are in communication with each other to form a cavity, and the silicon wafer is connected together above the cavity to seal the cavity.

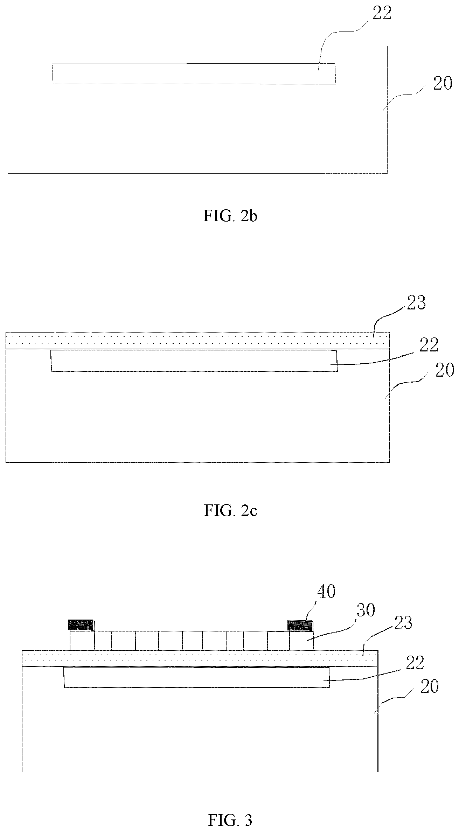

Appropriate heat treatment is performed on the silicon wafer 20 defined with the trenches 21. When the silicon wafer is heated to a certain temperature, the vibration energy of the silicon atoms is relatively large, resulting in strengthening of the movement energy of the atoms, and the silicon atoms will migrate. Since the silicon wafer is defined with trenches and the distance between the sidewalls of the trench is small, when the migration of the silicon atoms reaches a certain level, the silicon atoms will enter the trenches 21, and the trenches 21 inside the silicon wafer will be deformed. The upper portions of the trenches 21 are closed by silicon, and the middle portions of the plurality of trenches 21 are in communication with each other to form a cavity 22 (as shown in Fig. 2b). That is, the cavity 22 is in the middle of the silicon wafer, the upper and lower portions of the cavity 22 have silicon structures, and the upper and lower silicon structures are separated by the cavity 22. In an embodiment, the temperature of thermal annealing may be 1000 °C. By changing the spacing between the trenches 21, cavities of different shapes can be obtained, and the larger the spacing, the higher temperature of the annealing required, but the duration of the annealing does not exceed 20 minutes. In this embodiment, in the trench array, the spacing between the outermost trenches is greater than the spacing between the inner trenches, in this way, the formation of a gap at the edges of the cavity can be avoided. At the same time, the thermal annealing needs to be performed in an isolation environment, such as a vacuum environment or an inert gas environment, so as to ensure that silicon will not chemically react with substances in the environment during the thermal annealing process. In this embodiment, the thermal annealing is performed in a hydrogen environment.

Step S130: oxidizing the silicon wafer at the upper portion of the cavity to obtain a silicon oxide film.

The silicon wafer at the upper portion of the cavity is oxidized by a thermal oxidation process to form a silicon oxide film 23 (as shown in FIG. 2c). In a high temperature environment of 900 °C to 1200 °C, by externally supplying oxygen or water vapor to chemically react with the silicon, a thermally grown oxide layer can be obtained above the cavity. Since the oxidation reaction almost stops when the oxide layer reaches a certain thickness, when it is difficult to oxidize all the silicon above the cavity into silicon oxide through one single oxidation process, it is necessary to oxidize all the silicon above the cavity through multiple oxidation steps. Specifically, a silicon oxide film is generated by performing a first thermal oxidation, such that remaining unoxidized silicon and the silicon oxide film generated on the silicon are above the cavity. The uppermost silicon oxide film is then removed by an etching process and the silicon above the cavity is remained, at this time, the thickness of the silicon is reduced. The thickness of the silicon above the cavity is then continued to be gradually reduced through the above cyclic process of thermal oxidation, etching, and thermal oxidation, until all the silicon above the cavity forms the silicon oxide film after the last thermal oxidation. Thus, the upper silicon oxide film can be separated from the lower silicon by the cavity. At this time, the manufacturing of the substrate of the temperature sensor is finished.

In an embodiment, after the above silicon oxide film is obtained, a silicon nitride film or a polyimide film can further be formed on the silicon oxide film. Due to a large stress existed inside the silicon oxide, the silicon oxide film is easy to break. By depositing a silicon nitride film or a polyimide film on the silicon oxide film, the stress inside the silicon oxide can be balanced and the structure of the silicon oxide film can be more stable.

Step S140: forming a temperature measurement unit on the silicon oxide film, the temperature measurement unit is configured to sense an ambient temperature.

After manufacturing of the substrate of the temperature sensor is finished, a temperature measurement unit needs to be formed on the substrate. The temperature measurement unit is a working unit of the temperature sensor. The temperature sensor senses the temperature through the temperature measurement unit to form an electrical signal and output it.

In an embodiment, the temperature measurement unit is a thermal resistance sensing structure, and its specific forming process includes:
Step S141: depositing a first metal layer on the silicon oxide film, the first metal layer is a metal platinum layer, and the metal platinum layer has a continuous bow shaped structure.

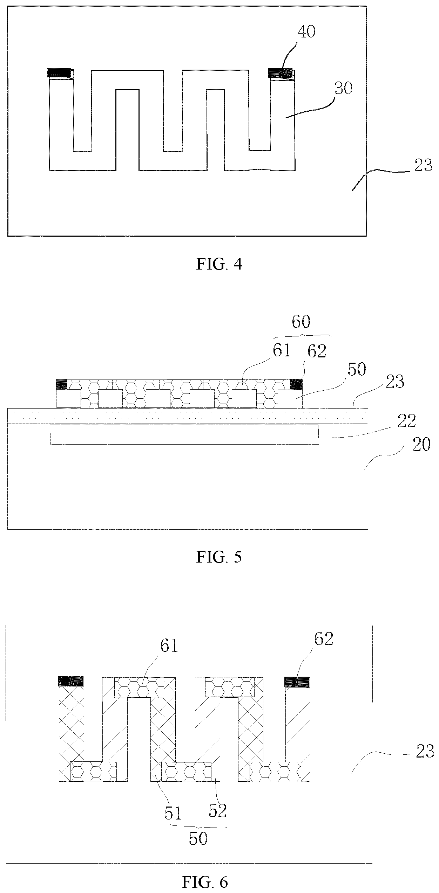

Referring to FIG. 3, a first metal layer 30 is deposited on the silicon oxide film 23. The first metal layer 30 may be a metal platinum layer, that is, the thermal resistance sensing structure is selected to be a platinum thermal resistance. In another embodiment, other materials with higher temperature coefficient of resistance, such as nickel, iron, and the like, can also be selected. In order to reduce the size of the temperature sensor, the contact area of the platinum thermal resistance is increased on a small-sized substrate, and the platinum thermal resistance is made into a continuous bow shaped structure (as shown in FIG. 4).

Step S142: depositing a second metal layer on each of two outermost ends of the platinum metal layer for leading out an output terminal of the temperature sensor.

Continuing to refer to FIGS. 3 and 4, a second metal layer 40 is deposited on each of the two outermost ends of the platinum metal layer 30. The second metal layer 40 may be a metal aluminum layer, and the output terminal of the temperature sensor is led out from the metal aluminum. That is, the output wire of the temperature sensor is connected to the aluminum layer, so as to be connected to the metal platinum layer through the aluminum layer.

The above platinum thermal resistance sensor measures the temperature by using the characteristic that the resistance value of metal platinum changes as the temperature changes. The output terminal of the temperature sensor is connected to a display instrument, and the display instrument will display the temperature value corresponding to the obtained platinum resistance which is affected by the temperature.

Usually, forming the temperature measurement unit further includes a passivation step, that is,
Step S143: forming a passivation layer on the metal layer, and defining a through hole on the passivation layer at a corresponding place where the output terminal is to be led out for the temperature sensor.

Since the upper layer of the thermal resistance sensor has a metal structure such as metal aluminum or metal platinum, and a passivation layer is further formed on the metal layer that is easily oxidized when directly exposed to the air, the metal layer can be protected. At the same time, a through hole needs to be defined at a corresponding place where a terminal is to be led out for the temperature sensor, and the output terminal can be led out through the through hole. In this embodiment, through holes are defined in the passivation layer above the metal aluminum at the two ends. The passivation layer may be a silicon oxide layer or a silicon nitride layer, or a stacked silicon oxide layer and silicon nitride layer.

In an embodiment, the temperature measurement unit is a thermocouple sensing structure, and its specific forming process is:
Step S144: depositing a polysilicon layer on the silicon oxide film, the polysilicon layer includes an N-type polysilicon strip and a P-type polysilicon strip arranged side by side and spaced apart.

As shown in FIG. 5 and FIG. 6, a polysilicon layer 50 is deposited on the silicon oxide film 23. The polysilicon layer 50 includes N-type polysilicon strips 51 and P-type polysilicon strips 52 arranged side by side and spaced apart. The N-type polysilicon can be polysilicon having a conductivity type of N-type formed by doping group V elements inside polysilicon, and the interior of the polysilicon is uniformly doped. The P-type polysilicon can be polysilicon having a conductivity type of P-type formed by doping group III elements inside polysilicon, and the interior of the polysilicon is uniformly doped. The shape of the N-type polysilicon strip is the same as that of the P-type polysilicon strip. In this solution, the N-type polysilicon strip and the P-type polysilicon strip are long strip shaped, and the polysilicon strips are arranged in parallel and have the same spacing.

Step S145: depositing a third metal layer on the polysilicon layer. The third metal layer includes a first metal structure located between adjacent polysilicon strips, and the N-type polysilicon strips and the P-type polysilicon strips are connected in series through the first metal structure. The third metal layer further includes a second metal structure located at the two outermost ends of the polysilicon layer for leading out the output terminal of the temperature sensor.

Continuing to refer to FIG. 5 and FIG. 6, a third metal layer 60 is deposited on the polysilicon layer 50, and the third metal layer 60 includes first metal structures 61 and second metal structures 62. The first metal structures 61 are located between adjacent polysilicon strips so as to connect the polysilicon strips, specifically located at the ends of the adjacent polysilicon strips. All the N-type polysilicon strips 51 and the P-type polysilicon strips 52 are formed into a series structure through the first metal structures 61. Therefore, when there are M polysilicon strips, M-1 first metal structures 61 are needed to connect these polysilicon strips in series. One N-type polysilicon strip and one P-type polysilicon strip are connected in series to form one Seebeck structure. In this solution, a plurality of Seebeck structures is connected in series to form a temperature measurement unit. Therefore, M has to be an even number. The second metal structure 62 is deposited on the two outermost ends of the polysilicon layer to facilitate leading out the output terminal of the temperature sensor. In this embodiment, the third metal layer 60 is a metal aluminum layer.

In the above thermocouple sensing structure, it is used that, when the temperatures at two ends of the semiconductor are not the same, a thermoelectromotive force will be generated inside the semiconductor. Different types of semiconductors have different thermoelectromotive forces. When two ends of two types of semiconductors are connected to form a closed loop, current is generated in the loop, and when the temperature difference between the two ends of the semiconductor is different, the electromotive force generated is different. In this solution, an N-type semiconductor and a P-type semiconductor are used to form a Seebeck structure, and a plurality of Seebeck structures are connected in series, which can enhance the sensitivity of the temperature sensor. In an embodiment, the two output terminals of the temperature sensor may be used as a cold junction and the temperature of the cold junction is kept constant, and the polysilicon layer connected in series may be used as a hot junction to sense the actual ambient temperature. When the ambient temperature changes, the temperature difference between the cold junction and the hot junction changes, so that the potential of the cold junction will change. After connecting with the display instrument, the display instrument will display the temperature of the hot junction corresponding to the obtained potential of the thermocouple affected by the current ambient temperature, that is, the current ambient temperature.

Usually, forming the temperature measurement unit further includes a passivation step, that is,
Step S146: forming a passivation layer on the metal layer, and defining a through hole on the passivation layer at a corresponding place where the output terminal is to be led out for the temperature sensor.

Since the upper layer of the thermocouple sensor has a metal structure such as a metal aluminum layer, and a passivation layer is further formed on the metal layer that is easily oxidized when directly exposed to the air, the metal structure can be protected. At the same time, a through hole needs to be defined at a corresponding place where a terminal is to be led out for the temperature sensor, and the output terminal can be led out through the through hole. In this embodiment, through holes are defined in the passivation layer above the metal aluminum at the ends of the outer side polysilicon. The passivation layer may be a silicon oxide layer or a silicon nitride layer, or a stacked silicon oxide layer and silicon nitride layer.

With the above manufacturing method for a temperature sensor, a silicon oxide film can be obtained, and the silicon oxide film is separated from silicon by a cavity. The silicon below the cavity will not affect the isolation effect of the silicon oxide film above the cavity, therefore there is no need to etch the excess silicon through a deep trench etching process, such that the manufacturing process is simplified, the manufacturing time is saved, and the manufacturing cost is saved. Due to the low thermal conductivity of the silicon oxide film, it will have a better temperature measurement effect when the temperature measurement unit is manufactured on the silicon oxide film, which makes the performance of the temperature sensor more stable.

An example not forming part of the present invention relates to a temperature sensor, including:
a substrate, including a silicon wafer and a silicon oxide film formed on the silicon wafer, and a cavity is formed between the silicon wafer and the silicon oxide film; and
a temperature measurement unit, formed on the silicon oxide film above the cavity, and the temperature measurement unit is configured to sense an ambient temperature.

As shown in FIG. 2c, the substrate includes a silicon wafer 20 and a silicon oxide film 23, and a cavity 22 is formed between the silicon wafer 20 and the silicon oxide film 23. The temperature measurement unit is a working unit of the temperature sensor. The temperature sensor senses the temperature through the temperature measurement unit to form an electrical signal and output it. In this solution, the temperature measuring unit is formed on the silicon oxide film 23 and located above the cavity.

In an embodiment, the temperature measurement unit is a thermal resistance sensing structure, including:
a first metal layer, being a metal platinum layer, and the metal platinum layer has a continuous bow shaped structure; and
a second metal layer, located at two outermost ends of the platinum metal layer for leading out an output terminal of the temperature sensor.

As shown in FIG. 3 and FIG. 4, a first metal layer 30 is deposited on the silicon oxide film 23. The first metal layer 30 is a metal platinum layer, that is, the thermal resistance sensing structure is selected to be a platinum thermal resistance. In another embodiment, other materials with higher temperature coefficient of resistance, such as nickel, iron, and the like, can also be selected. In order to reduce the size of the temperature sensor, the contact area of the platinum thermal resistance is increased on a small-sized substrate, and the platinum thermal resistance has a continuous bow shaped structure (as shown in FIG. 4). A second metal layer 40 is deposited on each of the two outermost ends of the platinum metal layer 30. The second metal layer 40 may be a metal aluminum layer, for leading out the output terminal of the temperature sensor from the metal aluminum. That is, the output wire of the temperature sensor is connected to the aluminum layer, so as to be connected to the metal platinum layer through the aluminum layer.

The above platinum thermal resistance sensor measures the temperature by using the characteristic that the resistance value of metal platinum changes as the temperature changes. The output terminal of the temperature sensor is connected to a display instrument, and the display instrument will display the temperature value corresponding to the obtained platinum resistance which is affected by the temperature.

In an embodiment, since the upper layer of the thermal resistance sensor has a metal structure such as metal aluminum and metal platinum, and a passivation layer is further formed on the metal layer that is easily oxidized when directly exposed to the air, the metal layer can be protected. At the same time, a through hole needs to be defined at a corresponding place where a terminal is to be led out for the temperature sensor, and the output terminal can be led out through the through hole. In this embodiment, through holes are defined in the passivation layer above the metal aluminum at the two ends. The passivation layer may be a silicon oxide layer or a silicon nitride layer, or a stacked silicon oxide layer and silicon nitride layer.

In an embodiment, the temperature measurement unit is a thermocouple sensing structure, including:
a polysilicon layer, including an N-type polysilicon strip and a P-type polysilicon strip arranged side by side and spaced apart; and
a third metal layer, including a first metal structure located between adjacent polysilicon strips, and the N-type polysilicon strip and the P-type polysilicon strip are connected in series through the first metal structure. The third metal layer further includes a second metal structure located at the two outermost ends of the polysilicon layer for leading out the output terminal of the temperature sensor.

As shown in FIG. 5 and FIG. 6, a polysilicon layer 50 is formed on the silicon oxide film 23. The polysilicon layer 50 includes N-type polysilicon strips 51 and P-type polysilicon strips 52 arranged side by side and spaced apart. The N-type polysilicon can be polysilicon having a conductivity type of N-type formed by doping group V elements inside polysilicon, and the interior of the polysilicon is uniformly doped. The P-type polysilicon can be polysilicon having a conductivity type of P-type formed by doping group III elements inside polysilicon, and the interior of the polysilicon is uniformly doped. The shape of the N-type polysilicon strip is the same as that of the P-type polysilicon strip. In this solution, the N-type polysilicon strip and the P-type polysilicon strip are long strip shaped, and the polysilicon strips are arranged in parallel and have the same spacing. A third metal layer 60 is deposited on the polysilicon layer 50, and the third metal layer 60 includes first metal structures 61 and second metal structures 62. The first metal structures 61 are located between adjacent polysilicon strips, and the polysilicon strips are connected through the first metal structures 61, the first metal structures 61 are specifically located at the ends of the adjacent polysilicon strips. All the N-type polysilicon strips 51 and the P-type polysilicon strips 52 are formed into a series structure through the first metal structures 61. Therefore, when there are M polysilicon strips, M-1 first metal structures 61 are needed to connect these polysilicon strips in series. One N-type polysilicon strip and one P-type polysilicon strip are connected in series to form one Seebeck structure. In this solution, a plurality of Seebeck structures are connected in series to form a temperature measurement unit. Therefore, M has to be an even number. The second metal structure 62 is deposited on the two outermost ends of the polysilicon layer to facilitate leading out the output terminal of the temperature sensor. In this embodiment, the third metal layer 60 is a metal aluminum layer.

In the above thermocouple sensing structure, it is used that, when the temperatures at two ends of two different types of semiconductors are not the same, a thermoelectromotive force will be generated inside the semiconductor. Different types of semiconductors have different thermoelectromotive forces. When two ends of two types of semiconductors are connected to form a closed loop, current is generated in the loop, and when the temperature difference between the two ends of the semiconductor is different, the electromotive force generated is different. In this solution, an N-type semiconductor and a P-type semiconductor are used to form a Seebeck structure, and a plurality of Seebeck structures are connected in series, which can enhance the sensitivity of the temperature sensor. In an embodiment, the two output terminals of the temperature sensor may be used as a cold junction and the temperature of the cold junction is kept constant, and the polysilicon layer connected in series may be used as a hot junction to sense the actual ambient temperature. When the ambient temperature changes, the temperature difference between the cold junction and the hot junction changes, so that the potential of the cold junction will change. After connecting with the display instrument, the display instrument will display the temperature of the hot junction corresponding to the obtained potential of the thermocouple affected by the current ambient temperature, that is, the current ambient temperature.

Since the upper layer of the thermocouple sensor has a metal structure, and a passivation layer further needs to be formed on the metal layer that is easily oxidized when directly exposed to the air, the metal structure can be protected. At the same time, a through hole needs to be defined at a corresponding place where a terminal is to be led out for the temperature sensor, and the output terminal can be led out through the through hole. In this embodiment, through holes are defined in the passivation layer above the metal aluminum at the ends of the outer side polysilicon. The passivation layer may be a silicon oxide layer or a silicon nitride layer, or a stacked silicon oxide layer and silicon nitride layer.

In the above temperature sensor, the temperature measurement unit is disposed on the silicon oxide film, and the silicon oxide film has a relatively low thermal conductivity, therefore the temperature measurement effect of the temperature measuring unit will not be affected. In addition, a cavity is formed between the silicon oxide film and the silicon. The silicon below the cavity will not affect the isolation effect of the silicon oxide above the cavity. During the manufacturing process of the temperature sensor, there is no need to etch the excess silicon through a deep trench etching process, thus greatly simplifying the manufacturing time of the temperature sensor and saving the cost.

The technical features of the above-described embodiments may be combined arbitrarily. To simplify the description, not all the possible combinations of the technical features in the above embodiments are described. However, all of the combinations of these technical features should be considered as within the scope of this application, as long as such combinations do not contradict with each other.

The protection scope of the present application shall be subject to the appended claims.

## Claims

1. A manufacturing method for a temperature sensor, comprising:
forming (S110) a plurality of trenches (21) on a silicon wafer (20);
performing (S120) thermal annealing to deform the plurality of trenches (21), such that the plurality of trenches (21) are in communication with each other to form a cavity (22), and the silicon wafer (20) is connected together above the cavity (22) to seal the cavity (22);
oxidizing (S130) silicon above the cavity (22) to obtain a silicon oxide film (23); and
forming (S140) a temperature measurement unit on the silicon oxide film (23), and the temperature measurement unit is configured to sense an ambient temperature.

2. The manufacturing method of claim 1, wherein a width of the trench (21) is in a range of 0.6 µm to 1 µm, a depth of the trench (21) is in a range of 1 µm to 10 µm, and a spacing between adjacent trenches (21) is in a range of 0.6 µm to 1 µm.

3. The manufacturing method of claim 1, wherein a spacing between outermost trenches (21) is greater than a spacing between inner trenches (21).

4. The manufacturing method of claim 1, wherein the thermal annealing specifically refers to thermal annealing in a hydrogen environment, and a temperature of the thermal annealing is 1000 °C.

5. The manufacturing method of claim 1, wherein a duration of the thermal annealing does not exceed 20 min.

6. The manufacturing method of claim 1, wherein the oxidizing (S130) silicon above the cavity (22) to obtain the silicon oxide film (23) specifically comprises: oxidizing the silicon wafer at an upper portion of the cavity through a thermal oxidation process in a high temperature environment of 900 °C to 1200 °C to form the silicon oxide film.

7. The manufacturing method of claim 6, wherein the oxidizing (S130) silicon above the cavity (22) to obtain the silicon oxide film (23) specifically comprises:
generating a silicon oxide film by performing a first thermal oxidation, such that remaining unoxidized silicon and the silicon oxide film generated on the silicon are above the cavity;
removing the silicon oxide film uppermost by an etching process and remaining the silicon above the cavity, such that a thickness of the silicon is reduced at this time; and
continuing to gradually reduce the thickness of the silicon above the cavity through a cyclic process of thermal oxidation, etching, and thermal oxidation, until all the silicon above the cavity forms the silicon oxide film after a last thermal oxidation.

8. The manufacturing method of claim 1, further comprising, after obtaining the silicon oxide film, forming a silicon nitride film or a polyimide film on the silicon oxide film.

9. The manufacturing method of claim 1, wherein the forming (S140) the temperature measurement unit on the silicon oxide film (23) specifically comprises:
depositing (S141) a first metal layer on the silicon oxide film, the first metal layer being a metal platinum layer, and the metal platinum layer having a continuous bow shaped structure; and
depositing (S142) a second metal layer on each of two outermost ends of the platinum metal layer for leading out an output terminal of the temperature sensor.

10. The manufacturing method of claim 1, wherein the forming (S140) the temperature measurement unit on the silicon oxide film (23) specifically comprises:
depositing (S144) a polysilicon layer on the silicon oxide film, the polysilicon layer comprising an N-type polysilicon strip and a P-type polysilicon strip arranged side by side and spaced apart; and
depositing (S145) a third metal layer on the polysilicon, the third metal layer comprising a first metal structure located between adjacent polysilicon strips, and the N-type polysilicon strip and the P-type polysilicon strip being connected in series through the first metal structure, the third metal layer further comprising a second metal structure located at two outermost ends of the polysilicon layer for leading out an output terminal of the temperature sensor.

11. The manufacturing method of claim 9, further comprising:
forming (S143) a passivation layer on the metal layer, and defining a through hole on the passivation layer at a corresponding place where the output terminal is to be led out for the temperature sensor.

12. The manufacturing method of claim 10, wherein the N-type polysilicon strip and the P-type polysilicon strip are long strip shaped, and the polysilicon strips are arranged in parallel and have a same spacing.

## Patentansprüche

1. Herstellungsverfahren für einen Temperatursensor, Folgendes umfassend:
Ausbilden (S110) von mehreren Gräben (21) auf einem Silizium-Wafer (20);
Durchführen (S120) von thermischem Tempern, um die mehreren Gräben (21) zu deformieren, so dass die mehreren Gräben (21) miteinander in Verbindung stehen, um einen Hohlraum (22) auszubilden, und der Silizium-Wafer (20) über dem Hohlraum (22) zusammen verbunden ist, um den Hohlraum (22) abzudichten;
Oxidieren (S130) von Silizium über dem Hohlraum (22), um einen Siliziumoxid-Film (23) zu erlangen; und
Ausbilden (S140) einer Temperaturmesseinheit auf dem Siliziumoxid-Film (23), und wobei die Temperaturmesseinheit eingerichtet ist, um eine Umgebungstemperatur zu messen.

2. Herstellungsverfahren nach Anspruch 1, wobei eine Breite des Grabens (21) in einem Bereich von 0,6 µm bis 1 um ist, eine Tiefe des Grabens (21) in einem Bereich von 1 um bis 10 um ist und ein Abstand zwischen benachbarten Gräben (21) in einem Bereich von 0,6 µm bis 1 um ist.

3. Herstellungsverfahren nach Anspruch 1, wobei ein Abstand zwischen äußersten Gräben (21) größer ist als ein Abstand zwischen inneren Gräben (21).

4. Herstellungsverfahren nach Anspruch 1, wobei das thermische Tempern insbesondere ein thermisches Tempern in einer Wasserstoff-Umgebung betrifft und eine Temperatur des thermischen Temperns 1000 °C ist.

5. Herstellungsverfahren nach Anspruch 1, wobei eine Dauer des thermischen Temperns 20 min nicht übersteigt.

6. Herstellungsverfahren nach Anspruch 1, wobei das Oxidieren (S130) von Silizium über dem Hohlraum (22), um den Siliziumoxid-Film (23) zu erlangen, insbesondere Folgendes umfasst: Oxidieren des Silizium-Wafers an einem oberen Abschnitt des Hohlraums durch einen thermischen Oxidationsprozess in einer Hochtemperaturumgebung von 900 °C bis 1200 °C, um den Siliziumoxid-Film auszubilden.

7. Herstellungsverfahren nach Anspruch 6, wobei das Oxidieren (S130) von Silizium über dem Hohlraum (22), um den Siliziumoxid-Film (23) zu erlangen, insbesondere Folgendes umfasst:
Erzeugen eines Siliziumoxid-Films durch Durchführen einer ersten thermischen Oxidation, so dass verbleibendes nicht oxidiertes Silizium und der Siliziumoxid-Film, der auf dem Silizium erzeugt wurde, über dem Hohlraum sind;
Entfernen des allerobersten Siliziumoxid-Films durch einen Ätzprozess und Zurücklassen des Siliziums über dem Hohlraum, so dass eine Dicke des Siliziums zu diesem Zeitpunkt reduziert ist; und
Fortsetzen, die Dicke des Siliziums über dem Hohlraum durch einen zyklischen Prozess aus thermischer Oxidation, Ätzen und thermischer Oxidation allmählich zu reduzieren, bis das gesamte Silizium über dem Hohlraum den Siliziumoxid-Film nach einer letzten thermischen Oxidation ausbildet.

8. Herstellungsverfahren nach Anspruch 1, weiterhin umfassend, nach Erlangen des Siliziumoxid-Films, Ausbilden eines Siliziumnitrid-Films oder eines Polyimid-Films auf dem Siliziumoxid-Film.

9. Herstellungsverfahren nach Anspruch 1, wobei das Ausbilden (S140) der Temperaturmesseinheit auf dem Siliziumoxid-Film (23) insbesondere Folgendes umfasst:
Abscheiden (S141) einer ersten Metallschicht auf dem Siliziumoxid-Film, wobei die erste Metallschicht eine Platin-Metallschicht ist und die Platin-Metallschicht eine durchgehende bogenförmige Struktur aufweist; und
Abscheiden (S142) einer zweiten Metallschicht auf jedem von zwei äußersten Enden der Platin-Metallschicht zum Herausführen eines Ausgangsanschlusses des Temperatursensors.

10. Herstellungsverfahren nach Anspruch 1, wobei das Ausbilden (S140) der Temperaturmesseinheit auf dem Siliziumoxid-Film (23) insbesondere Folgendes umfasst:
Abscheiden (S144) einer Polysilizium-Schicht auf dem Siliziumoxid-Film, wobei die Polysilizium-Schicht einen n-leitenden Polysilizium-Streifen und einen p-leitenden Polysilizium-Streifen umfasst, die Seite an Seite angeordnet sind und voneinander beabstandet sind; und
Abscheiden (S145) einer dritten Metallschicht auf dem Polysilizium, wobei die dritte Metallschicht eine erste Metallstruktur umfasst, die zwischen benachbarten Polysilizium-Streifen angeordnet ist, und wobei der n-leitende Polysilizium-Streifen und der p-leitende Polysilizium-Streifen durch die erste Metallstruktur in Reihe geschaltet sind, wobei die dritte Metallschicht weiterhin eine zweite Metallstruktur umfasst, die an zwei äußersten Enden der Polysilizium-Schicht zum Herausführen eines Ausgangsanschlusses des Temperatursensors angeordnet ist.

11. Herstellungsverfahren nach Anspruch 9, weiterhin Folgendes umfassend:
Ausbilden (S143) einer Passivierungsschicht auf der Metallschicht und Definieren eines Durchgangslochs auf der Passivierungsschicht an einem entsprechenden Ort, an dem der Ausgangsanschluss für den Temperatursensor herausgeführt werden soll.

12. Herstellungsverfahren nach Anspruch 10, wobei der n-leitende Polysilizium-Streifen und der p-leitende Polysilizium-Streifen langstreifenförmig sind und die Polysilizium-Streifen parallel angeordnet sind und einen gleichen Abstand aufweisen.

## Revendications

1. Procédé de fabrication d'un capteur de température, comprenant :
la formation (S110) d'une pluralité de tranchées (21) sur une plaquette de silicium (20) ;
la réalisation (S120) d'un recuit thermique pour déformer la pluralité de tranchées (21), de telle sorte que la pluralité de tranchées (21) sont en communication les unes avec les autres pour former une cavité (22), et la plaquette de silicium (20) est connectée ensemble au-dessus de la cavité (22) pour sceller la cavité (22) ;
l'oxydation (S130) du silicium au-dessus de la cavité (22) pour obtenir un film d'oxyde de silicium (23) ; et
la formation (S140) d'une unité de mesure de température sur le film d'oxyde de silicium (23), et l'unité de mesure de température étant configurée pour détecter une température ambiante.

2. Procédé de fabrication selon la revendication 1, une largeur de la tranchée (21) étant comprise entre 0,6 um et 1 um, une profondeur de la tranchée (21) étant comprise entre 1 um et 10 um, et un espacement entre des tranchées adjacentes (21) étant compris entre 0,6 um et 1 um.

3. Procédé de fabrication selon la revendication 1, un espacement entre les tranchées les plus extérieures (21) étant supérieur à un espacement entre les tranchées intérieures (21).

4. Procédé de fabrication selon la revendication 1, le recuit thermique se référant spécifiquement au recuit thermique dans un environnement d'hydrogène, et une température du recuit thermique étant de 1000 °C.

5. Procédé de fabrication selon la revendication 1, une durée du recuit thermique n'excédant pas 20 min.

6. Procédé de fabrication selon la revendication 1, l'oxydation (S130) du silicium au-dessus de la cavité (22) pour obtenir le film d'oxyde de silicium (23) comprenant spécifiquement : l'oxydation de la plaquette de silicium à une partie supérieure de la cavité par un processus d'oxydation thermique dans un environnement à haute température de 900 °C à 1200 °C pour former le film d'oxyde de silicium.

7. Procédé de fabrication selon la revendication 6, l'oxydation (S130) du silicium au-dessus de la cavité (22) pour obtenir le film d'oxyde de silicium (23) comprenant spécifiquement :
la génération d'un film d'oxyde de silicium en effectuant une première oxydation thermique, de telle sorte que le silicium non oxydé restant et le film d'oxyde de silicium généré sur le silicium se trouvent au-dessus de la cavité ;
le retrait du film d'oxyde de silicium en haut par un processus de gravure et le fait de laisser le silicium au-dessus de la cavité, de telle sorte que l'épaisseur du silicium est réduite à ce moment-là ; et
le fait de continuer à réduire progressivement l'épaisseur du silicium au-dessus de la cavité par un processus cyclique d'oxydation thermique, de gravure et d'oxydation thermique, jusqu'à ce que tout le silicium au-dessus de la cavité forme le film d'oxyde de silicium après une dernière oxydation thermique.

8. Procédé de fabrication selon la revendication 1, comprenant en outre, après l'obtention du film d'oxyde de silicium, la formation d'un film de nitrure de silicium ou d'un film de polyimide sur le film d'oxyde de silicium.

9. Procédé de fabrication selon la revendication 1, la formation (S140) de l'unité de mesure de température sur le film d'oxyde de silicium (23) comprenant spécifiquement :
le dépôt (S141) d'une première couche métallique sur le film d'oxyde de silicium, la première couche métallique étant une couche de platine métallique, et la couche de platine métallique ayant une structure en forme d'arc continu ; et
le dépôt (S142) d'une deuxième couche métallique sur chacune des deux extrémités les plus extérieures de la couche de platine métallique, afin d'alimenter une borne de sortie du capteur de température.

10. Procédé de fabrication selon la revendication 1, la formation (S140) de l'unité de mesure de température sur le film d'oxyde de silicium (23) comprenant spécifiquement :
le dépôt (S144) d'une couche de polysilicium sur le film d'oxyde de silicium, la couche de polysilicium comprenant une bande de polysilicium de type N et une bande de polysilicium de type P agencées côte à côte et espacées l'une de l'autre ; et
le dépôt (S145) d'une troisième couche métallique sur le polysilicium, la troisième couche métallique comprenant une première structure métallique située entre des bandes de polysilicium adjacentes, et la bande de polysilicium de type N et la bande de polysilicium de type P étant connectées en série à travers la première structure métallique, la troisième couche métallique comprenant en outre une deuxième structure métallique située aux deux extrémités les plus extérieures de la couche de polysilicium pour déboucher sur une borne de sortie du capteur de température.

11. Procédé de fabrication selon la revendication 9, comprenant en outre :
la formation (S143) d'une couche de passivation sur la couche métallique, et la définition d'un trou traversant sur la couche de passivation à un endroit correspondant où la borne de sortie doit être sortie pour le capteur de température.

12. Procédé de fabrication selon la revendication 10, la bande de polysilicium de type N et la bande de polysilicium de type P ayant la forme d'une longue bande, et les bandes de polysilicium étant agencées en parallèle et ayant un même espacement.
